# EUROPEAN PATENT APPLICATION

(11) **EP 4 664 125 A1**
(43) Date of publication of application: **17.12.2025**
(21) Application number: 25178775.0
(22) Date of filing: 26.05.2025
(51) Int. Cl.: G01R 31/327, B60L 3/00, H01M 10/48, H01H 47/00, G01R 31/00

(54) **RELAY FAILURE DIAGNOSING METHOD AND ELECTRICITY STORAGE DEVICE SYSTEM**

(30) Priority: 13.06.2024 JP 2024095518
(71) Applicant: Prime Planet Energy & Solutions, Inc., Chuo-ku, Tokyo 103-0022 (JP)
(72) Inventor: HIRAYAMA, Atsushi, Tokyo, 103-0022 (JP); SHOJI, Makoto, Tokyo, 103-0022 (JP); KOYAMA, Katsutoshi, Tokyo, 103-0022 (JP); YOSHINAGA, Masayuki, Tokyo, 103-0022 (JP)
(74) Representative: Kuhnen & Wacker Patent- und Rechtsanwaltsbüro PartG mbB

(57) **Abstract**

A relay failure diagnosing method is a relay failure diagnosing method for an electricity storage device system (1) that includes multiple electricity storage device packs (10, 20) each comprising a positive and negative relay (12, 13, 22, 23) and a precharge relay (14b, 24b). The relay failure diagnosing method is executed by a controller (50). The relay failure diagnosing method includes diagnosis processing (S1) and change processing (S2). In the diagnosis processing, a failure of a relay is diagnosed for one or some of the multiple electricity storage device packs at startup of the electricity storage device system. In the change processing, an electricity storage device pack that is to be a target of failure diagnosis is changed.

## Description

### BACKGROUND

The present disclosure relates to a relay failure diagnosing method and an electricity storage device system.

Japanese Laid-open Patent Publication No. 2017-117618 discloses a relay failure diagnosing method for multiple power sources connected to each other in parallel. Each of the power sources includes relays at both a positive electrode and a negative electrode. In the relay failure diagnosing method disclosed in Japanese Laid-open Patent Publication No. 2017-117618, while opening and closing drive is performed to switch between opening and closing of the relays, whether the relays operate in accordance with the opening and closing drive is diagnosed, based on voltages of the power sources. The opening and closing drive includes a first step, a second step, and a third step. In the first step, multiple relays provided at one of the positive electrode and the negative electrode are driven to be closed in order in a parallel direction. In the second step, the multiple relays provided at the one of the positive electrode and the negative electrode are collectively driven to be opened. In the third step, multiple relays provided at the other one of the positive electrode and the negative electrode are driven to be closed in order in the parallel direction.

### SUMMARY

The present inventors desire to reduce a time for diagnosing a failure of a relay included in an electricity storage device pack.

A relay failure diagnosing method is a relay failure diagnosing method for an electricity storage device system that includes multiple electricity storage device packs. The relay failure diagnosing method is executed by a controller. The relay failure diagnosing method includes diagnosis processing and change processing. In the diagnosis processing, a failure of a relay is diagnosed for one or some of the multiple electricity storage device packs at startup of the electricity storage device system. In the change processing, an electricity storage device pack that is to be a target of failure diagnosis is changed.

In the relay failure diagnosing method, a time for diagnosing the failures of the relays included in the electricity storage device packs is reduced.

### BRIEF DESCRIPTION OF THE DRAWINGS

FIG. 1 is a schematic view illustrating an electricity storage device system 1.
FIG. 2 is a flowchart illustrating processing that is executed in a controller 50.
FIG. 3 is a flowchart illustrating processing that is executed in the controller 50 at startup of the electricity storage device system 1.
FIG. 4 is a time chart illustrating states of relays.
FIG. 5 is a flowchart illustrating processing that is executed in the controller 50 at falling of the electricity storage device system 1.

### DETAILED DESCRIPTION OF THE EMBODIMENTS

Embodiments of a technology disclosed herein will be described below with reference to the accompanying drawings. As a matter of course, the embodiments described herein are not intended to be particularly limiting the present disclosure. The accompanying drawings are schematic and do not necessarily reflect actual members or portions. Members/portions that have the same effect will be denoted by the same sign as appropriate, and the overlapping description will be omitted as appropriate.

### <Electricity Storage Device System 1>

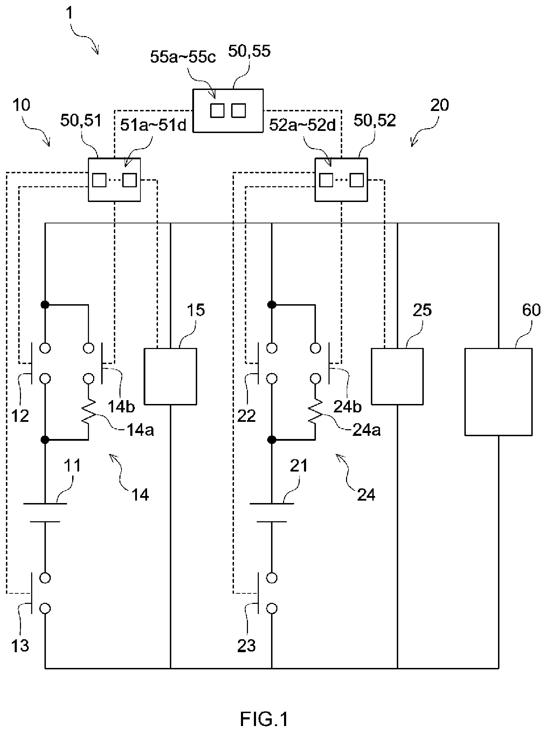

FIG. 1 is a schematic view illustrating an electricity storage device system 1. The electricity storage device system 1 is an assembly that includes an electricity storage device, a component that controls the electricity storage device, or the like and is also referred to as an electricity storage device pack. As illustrated in FIG. 1, the electricity storage device system 1 includes multiple electricity storage device packs 10 and 20 connected in parallel and a controller 50. In this embodiment, the electricity storage device system 1 includes two electricity storage device packs 10 and 20. The electricity storage device system 1 includes a first electricity storage device pack 10 and a second electricity storage device pack 20. Note that there is no particular limitation on the number of electricity storage device packs included in the electricity storage device system 1, and the number of electricity storage device packs may be three or more and may be, for example, four. There is no particular limitation on the number of electricity storage device packs included in the electricity storage device system 1, and the number of electricity storage device packs can be ten or less.

The electricity storage device system 1 is connected to a load 60 in series. Electric power is supplied to the load 60 from multiple electricity storage devices of the electricity storage device system 1. In this embodiment, the electricity storage device system 1 is connected to the load 60 of an electric vehicle. Although there is no particular limitation, the load 60 can be formed of, for example, an electric motor, an inverter, or the like of a vehicle. Note that the load 60 is not limited to the above-described form and the electricity storage device system 1 can be applied to some other system than an electricity storage device system that is mounted on an electric vehicle. The electricity storage device system 1 is connected to an unillustrated battery charger and is configured to be capable of charging and discharging.

The first electricity storage device pack 10 and the second electricity storage device pack 20 are connected in parallel. The first electricity storage device pack 10 and the second electricity storage device pack 20 are also connected to the load 60 in parallel.

### <Multiple Electricity Storage Device Packs 10 and 20>

Each of the multiple electricity storage device packs 10 and 20 includes a corresponding one of electricity storage devices 11 and 21 each including a positive electrode and a negative electrode, a corresponding one of positive electrode relays 12 and 22, and a corresponding one of negative electrode relays 13 and 23. Each of the positive electrode relays 12 and 22 is connected to a positive electrode side of a corresponding one of the electricity storage devices 11 and 21. Each of the negative electrode relays 13 and 23 is connected to a negative electrode side of a corresponding one of the electricity storage devices 11 and 21. Each of the electricity storage device packs 10 and 20 includes a corresponding one of low-order controllers 51 and 52. Each of the electricity storage device packs 10 and 20 includes a corresponding one of voltage sensors 15 and 25. The electricity storage device 11, the positive electrode relay 12, the negative electrode relay 13, the low-order controller 51, and the voltage sensor 15 of the first electricity storage device pack 10 are housed in an unillustrated pack case. The electricity storage device 21, the positive electrode relay 22, the negative electrode relay 23, the low-order controller 52, and the voltage sensor 25 of the second electricity storage device pack 20 are housed in an unillustrated pack case. Each of the pack cases is a sealed-type container formed of metal (for example, formed of aluminum or aluminum alloy).

### <Electricity Storage Devices 11 and 21>

Each of the electricity storage devices 11 and 21 is an electricity storage device from which energy can be taken. The electricity storage devices 11 and 21 encompass secondary batteries that can be repeatedly charged and discharged by moving of charge carriers between a pair of electrodes (a positive electrode and a negative electrode) via an electrolyte. The electricity storage devices 11 and 21 encompass, for example, lithium-ion secondary batteries, nickel-hydrogen batteries, or the like. Each of the electricity storage device packs 10 and 20 may include a single electricity storage device, and may include multiple electricity storage devices (cells). The multiple cells may be electrically connected to each other via a bus bar or the like to form an electricity storage device module. In the electricity storage device module, the multiple cells may be connected in series, may be connected in parallel, and may be connected such that serial connection and parallel connection are combined. There is no particular limitation on the number of the cells when the electricity storage devices 11 and 21 are an electricity storage device module. Each of the electricity storage devices 11 and 21 may include, for example, ten or more cells, and may include 100 or more cells. The number of cells included in each of the electricity storage devices 11 and 21 may be, for example, 200 or less. Each of the electricity storage devices 11 and 21 is connected to the load 60 via an unillustrated external output terminal to supply electric power to the load 60.

Each of the voltage sensors 15 and 25 is connected to a corresponding one of the electricity storage devices 11 and 21 in parallel. Voltages of the electricity storage devices 11 and 21 are detected by the voltage sensors 15 and 25. The voltage sensor 15 detects the voltage of the electricity storage device 11. The voltage sensor 25 detects of the voltage of the electricity storage device 21. When a malfunction occurs in one of the voltage sensors 15 and 25 or the like, one of the voltage sensors 15 and 25 may be configured to detect the voltages of both of the electricity storage devices 11 and 21. A single voltage sensor that detects both of the electricity storage devices 11 and 21 may be provided in the electricity storage device system 1. The voltages detected by the voltage sensors 15 and 25 are transmitted to the controller 50.

### <Positive Electrode Relays 12 and 22 and Negative Electrode Relays 13 and 23>

Each of the positive electrode relays 12 and 22 and each of the negative electrode relays 13 and 23 are connected to a corresponding one of the electricity storage devices 11 and 21 in series. There is no particular limitation on the positive electrode relays 12 and 22 and the negative electrode relays 13 and 23 as long as the positive electrode relays 12 and 22 and the negative electrode relays 13 and 23 can switch between connection and disconnection of the electricity storage devices 11 and 21 and the load 60. As the positive electrode relays 12 and 22 and the negative electrode relays 13 and 23, electromechanical relays may be used, and semiconductor relays may be used.

Each of the electricity storage device packs 10 and 20 includes a corresponding one of precharge circuits 14 and 24. Each of the precharge circuits 14 and 24 is a circuit in which a corresponding one of precharge resistances 14a and 24a and a corresponding one of precharge relays 14b and 24b are connected in series. The precharge circuits 14 and 24 are circuits that prevent a rush current from flowing into the load 60 when electric power is supplied from the electricity storage device system 1 to the load 60. Each of the precharge circuits 14 and 24 is connected to a corresponding one of the positive electrode relays 12 and 22 in parallel. Note that each of the precharge circuits 14 and 24 may be connected to a corresponding one of the negative electrode relays 13 and 23 in parallel.

Before the load 60 is started, the positive electrode relays 12 and 22, the negative electrode relays 13 and 23, and the precharge relays 14b and 24b are set in an open state. At startup of the electricity storage device system 1 connected to the load 60, the negative electrode relays 13 and 23 and the precharge relays 14b and 24b are switched to a close state. The load 60 is connected to the electricity storage device system 1 via the precharge circuits 14 and 24. At this time, electric power is supplied to the load 60 from the electricity storage devices 11 and 21 with a low current since the precharge resistances 14a and 24a are provided in the precharge circuits 14 and 24. Thereafter, the positive electrode relays 12 and 22 are put in a close state in a state where a potential of the load 60 is increased, and subsequently, the precharge relays 14b and 24b are put in an open state. Thus, a flow of a large current into the load 60 can be prevented. Opening and closing of the positive electrode relays 12 and 22, the negative electrode relays 13 and 23, and the precharge relays 14b and 24b are controlled by the controller 50. In this embodiment, opening and closing of the positive electrode relay 12, the negative electrode relay 13, and the precharge relay 14b is controlled by the low-order controller 51. Opening and closing of the positive electrode relay 22, the negative electrode relay 23, and the precharge relay 24b is controlled by the low-order controller 52.

### <Controller 50>

The controller 50 controls opening and closing of the positive electrode relays 12 and 22 and the negative electrode relays 13 and 23. The controller 50 is configured to be communicable with the voltage sensors 15 and 25.

The controller 50 can be a computer, such as, for example, an electronic control unit (ECU), a microcomputer-mounted circuit board, or the like. The computer can include an interface (I/F) that receives data or the like from an external device, a central processing unit (CPU) that executes an instruction of a program, a ROM in which the program that is executed by the CPU is stored, a RAM used as a working area in which the program is developed, and a memory device (recording medium), such as a memory or the like, that stores the program and various types of data. The relay failure diagnosing method disclosed herein can be embodied by cooperation of a preset program (software) and a computer (hardware) that executes the program. Relay failure diagnosis may be performed by multiple controllers in corporation. The relay failure diagnosing method may be realized by, for example, cooperative processing of multiple computers connected via a network.

In this embodiment, the controller 50 includes a high-order controller 55 and low-order controllers 51 and 52. The high-order controller 55 is configured to be communicable with the low-order controllers 51 and 52. The high-order controller 55 and the low-order controllers 51 and 52 can be configured to be communicable with each other via wired connection, wireless connection, or the like. The high-order controller 55 includes a storage 55a, an instructor 55b, and a determinator 55c. Each of the low-order controllers 51 and 52 includes a corresponding one of communicators 51a and 52a, a corresponding one of instructors 51b and 52b, a corresponding one of determinators 51c and 52c, and a corresponding one of acquisitors 51d and 52d. Each component of the controller 50 may be realized by one or more processors, or may be incorporated in a circuit. For each component of the low-order controller 51 and the low-order controller 52, the same processing is executed, and therefore, redundant description will be omitted as appropriate.

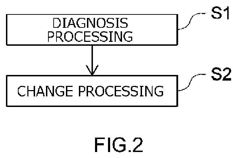

A relay failure diagnosing method disclosed herein will be described below. The relay failure diagnosing method for the electricity storage device system 1 including the multiple electricity storage device packs 10 and 20 is executed by the controller 50. FIG. 2 is a flowchart illustrating processing that is executed by the controller 50. As illustrated in FIG. 2, the relay failure diagnosing method includes diagnosis processing S1 of diagnosing a failure of a relay and change processing S2 of changing an electricity storage device pack that is to be a target of failure diagnosis.

### <Diagnosis Processing S1>

The diagnosis processing S1 is executed at startup of the electricity storage device system 1. In the diagnosis processing S1, the controller 50 diagnoses a failure of a relay for one of the multiple electricity storage device packs 10 and 20.

An order of failure diagnosis for the multiple electricity storage device packs 10 and 20 is stored in the controller 50 (in this embodiment, the storage 55a of the high-order controller 55). In this embodiment, the number of times of startup of the electricity storage device system 1 is stored. At odd-numbered startup of the electricity storage device system 1, whether there is a failure of a relay in the first electricity storage device pack 10 of the multiple electricity storage device packs 10 and 20 is diagnosed. At even-numbered startup of the electricity storage device system 1, whether there is a failure of a relay in the second electricity storage device pack 20 of the multiple electricity storage device packs 10 and 20 is diagnosed.

At odd-numbered startup of the electricity storage device system 1, the instructor 55b of the high-order controller 55 transmits an inspection instruction to the low-order controller 51. The inspection instruction can be a signal that is transmitted from the instructor 55b of the high-order controller 55. The communicator 51a of the low-order controller 51 receives the inspection instruction. When the inspection instruction is transmitted to the low-order controller 51 of the first electricity storage device pack 10, failure diagnosis of the electricity storage device 11 included in the first electricity storage device pack 10 is started.

The instructor 51b of the low-order controller 51 controls opening and closing of the positive electrode relay 12, the negative electrode relay 13, and the precharge relay 14b of the first electricity storage device pack 10 in a preset order.

At startup of the electricity storage device system 1, the positive electrode relay 12 and the negative electrode relay 13 of the electricity storage device pack 10 are set in an open state. Similarly, the positive electrode relay 22 and the negative electrode relay 23 of the electricity storage device pack 20 are set in an open state.

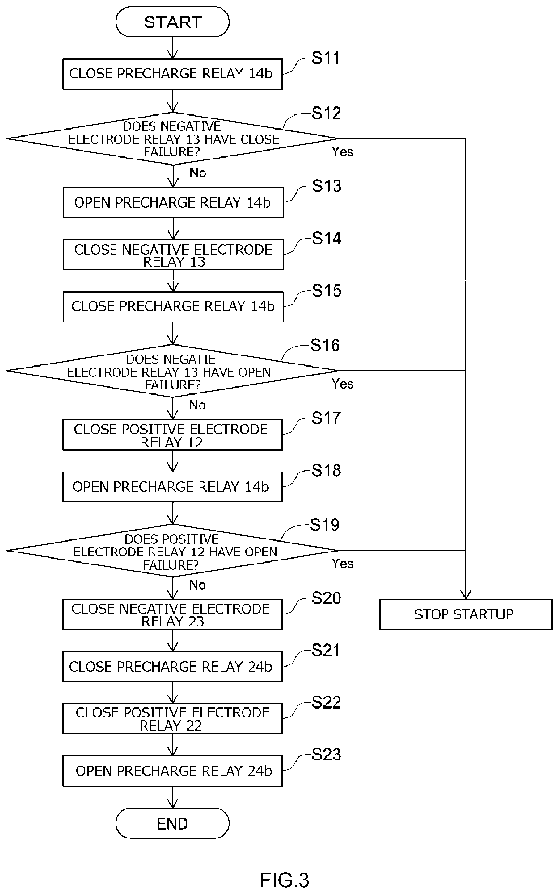

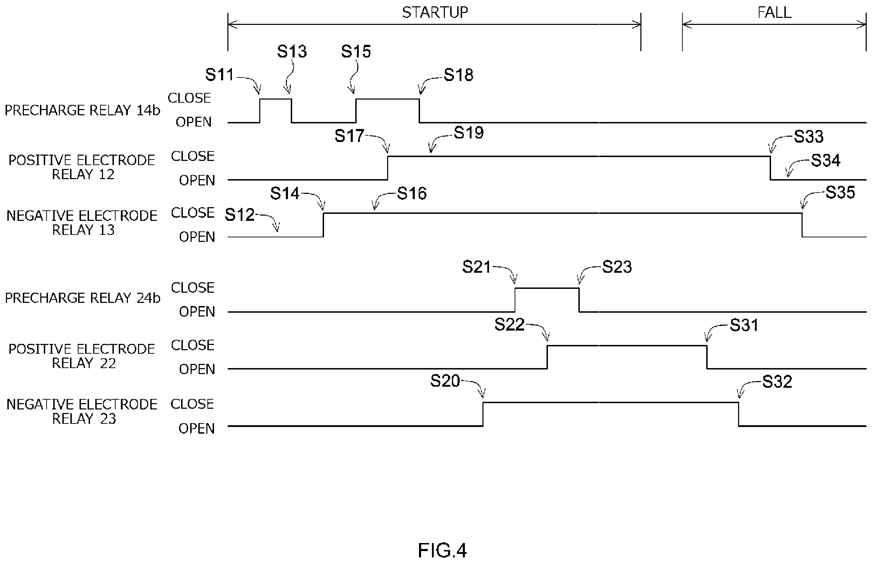

FIG. 3 is a flowchart illustrating processing that is executed by the controller 50 at startup of the electricity storage device system 1. In FIG. 3, processing that is executed at odd numbered startup of the electricity storage device system 1 is illustrated. FIG. 4 is a time chart illustrating states of the relays. In FIG. 4, processing that is executed by the controller 50 at startup and falling of the electricity storage device system 1 is illustrated.

As illustrated in FIG. 3 and FIG. 4, in Step S11, the instructor 51b instructs to put the precharge relay 14b of the electricity storage device pack 10 in a close state.

In Step S12, the determinator 51c determines, based on the voltage of the electricity storage device 11 that is acquired by the acquisitor 51d, whether the negative electrode relay 13 has a close failure. If the negative electrode relay 13 does not have a close failure (is normal), the electricity storage device 11 and the load 60 are not connected even when the precharge relay 14b is put in a close state. Therefore, the voltage of the electricity storage device 11 is not increased before and after opening and closing of the precharge relay 14b. When the negative electrode relay 13 has a close failure, the electricity storage device 11 and the load 60 are connected by the precharge relay 14b and the negative electrode relay 13 that has a close failure. When, after the precharge relay 14b is put in a close state, the voltage of the electricity storage device 11 is increased, the determinator 51c determines that the negative electrode relay 13 has a close failure. For example, a reference value of the voltage is set in advance and, when the voltage acquired by the acquisitor 51d is higher than the reference value, it may be determined that the negative electrode relay 13 has a close failure. Note that processing that is performed by the determinator 51c may be executed by the determinator 55c of the high-order controller 55.

When the negative electrode relay 13 has a close failure (Yes), it is notified to the high-order controller 55 from the communicator 51a of the low-order controller 51 that the negative electrode relay 13 has a close failure. The instructor 55b of the high-order controller 55 stops startup of the electricity storage device system 1. When the negative electrode relay 13 does not have a close failure (No), the process proceeds to Step S13.

In Step S13, the instructor 51b instructs to put the precharge relay 14b in an open state. In Step S14, the instructor 51b instructs to put the negative electrode relay 13 in a close state. In Step S15, the instructor 51b instructs to put the precharge relay 14b in a close state.

In Step S16, the determinator 51c determines, based on the voltage of the electricity storage device 11 that is acquired by the acquisitor 51d, whether the negative electrode relay 13 has an open failure. If the negative electrode relay 13 does not have an open failure (is normal), when the precharge relay 14b is put in a close state, the electricity storage device 11 and the load 60 are connected by the precharge relay 14b and the negative electrode relay 13. Therefore, after the precharge relay 14b is put in a close state, the voltage of the electricity storage device 11 is increased. When the negative electrode relay 13 has an open failure, the electricity storage device 11 and the load 60 are not connected. When, after the precharge relay 14b is put in a close state, the voltage of the electricity storage device 11 is not increased, the determinator 51c determines that the negative electrode relay 13 has an open failure. For example, a reference value of the voltage is set in advance and, when the voltage acquired by the acquisitor 51d is lower than the reference value, it may be determined that the negative electrode relay 13 has an open failure.

When the negative electrode relay 13 has an open failure (Yes), it is notified to the high-order controller 55 from the communicator 51a of the low-order controller 51 that the negative electrode relay 13 has an open failure. The instructor 55b of the high-order controller 55 stops startup of the electricity storage device system 1. When the negative electrode relay 13 does not have an open failure (No), the process proceeds to Step S17.

In Step S17, the instructor 51b instructs to put the positive electrode relay 12 in a close state. After the voltage of the load 60 is increased, in Step S18, the instructor 51b instructs to put the precharge relay 14b in an open state.

In Step S19, the determinator 51c determines, based on the voltage of the electricity storage device 11 that is acquired by the acquisitor 51d, whether the positive electrode relay 12 has an open failure. If the positive electrode relay 12 does not have an open failure (is normal), when the precharge relay 14b is put in an open state, the electricity storage device 11 and the load 60 are connected by the positive electrode relay 12 and the negative electrode relay 13. Therefore, the voltage of the electricity storage device 11 is constant before and after opening and closing of the precharge relay 14b. When the positive electrode relay 12 has an open failure, connection of the electricity storage device 11 and the load 60 is cut off. When, after the precharge relay 14b is put in a close state, the voltage of the electricity storage device 11 is reduced, the determinator 51c determines that the positive electrode relay 12 has an open failure.

When the positive electrode relay 12 has an open failure (Yes), it is notified to the high-order controller 55 from the communicator 51a of the low-order controller 51 that the positive electrode relay 12 has an open failure. The instructor 55b of the high-order controller 55 stops startup of the electricity storage device system 1. When the positive electrode relay 12 does not have an open failure (No), the process proceeds to Step S20.

When a close failure and an open failure of the negative electrode relay 13 and an open failure of the positive electrode relay 12 are detected until Step S19, the first electricity storage device pack 10 is normally started up. After the first electricity storage device pack 10 is started up, the second electricity storage device pack 20 is started up. Startup of the second electricity storage device pack 20 may be instructed by, for example, the high-order controller 55 that has not detected a failure of the first electricity storage device pack 10 until Step S19. For example, the instructor 55b of the high-order controller 55 may be configured to transmit a normal startup instruction to the low-order controller 52. The low-order controller 52 may be configured to receive the normal startup instruction by the communicator 52a to start startup of the second electricity storage device pack 20.

After failure diagnosis of the first electricity storage device pack 10, the instructor 52b of the low-order controller 52 controls the positive electrode relay 22, the negative electrode relay 23, and the precharge relay 24b of the second electricity storage device pack 20 to a close state in a preset order. At this time, failure diagnosis of the second electricity storage device pack 20 is not performed.

In Step S20, the instructor 52b instructs to put the negative electrode relay 23 in a close state. In Step S21, the instructor 52b instructs to put the precharge relay 24b in a close state. In Step S22, the instructor 52b instructs to put the positive electrode relay 22 in a close state. In Step S23, the instructor 52b instructs to put the precharge relay 24b in an open state. Thus, the second electricity storage device pack 20 is started up.

In the embodiment described above, after startup of the first electricity storage device pack 10 on which diagnosis processing has been performed, at startup of the second electricity storage device pack 20, diagnosis processing is not performed. Thus, a time for startup of the electricity storage device system 1 is reduced.

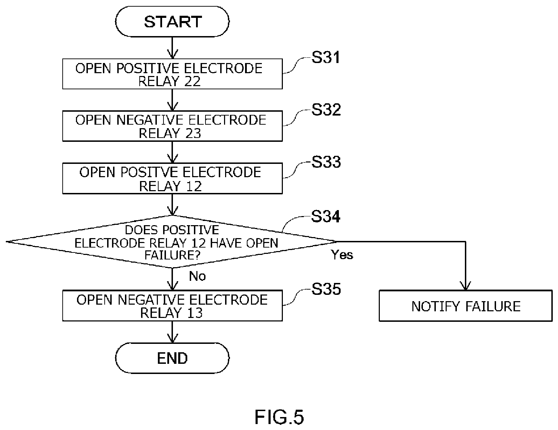

FIG. 5 is a flowchart illustrating processing that is executed by the controller 50 at falling of the electricity storage device system 1. As illustrated in FIG. 4 and FIG. 5, at falling after odd-numbered startup of the electricity storage device system 1, after the electricity storage device pack 20 falls, the electricity storage device pack 10 falls.

In Step S31, the instructor 52b instructs to put the positive electrode relay 22 of the second electricity storage device pack 20 in an open state. In Step S32, the instructor 52b instructs to put the negative electrode relay 23 in an open state. Thus, falling of the second electricity storage device pack 20 is completed.

In Step S33, the instructor 51b instructs to put the positive electrode relay 12 of the first electricity storage device pack 10 in an open state. In Step S34, the determinator 51c determines, based on the voltage of the electricity storage device 11 that is acquired by the acquisitor 51d, whether the positive electrode relay 12 has a close failure. If the positive electrode relay 12 does not have a close failure (is normal), when the positive electrode relay 12 is put in an open state, connection of the electricity storage device 11 and the load 60 is cut off. Therefore, after the positive electrode relay 12 is put in an open state, the voltage of the electricity storage device 11 is reduced. When the positive electrode relay 12 has a close failure, the electricity storage device 11 and the load 60 are caused to remain connected by the positive electrode relay 12 that has a close failure and the negative electrode relay 13. When, after the positive electrode relay 12 is put in an open state, the voltage of the electricity storage device 11 is not reduced, the determinator 51c determines that the positive electrode relay 12 has a close failure. In this case, it is notified to the high-order controller 55 that the positive electrode relay 12 has an open failure.

In Step S35, the instructor 51b instructs to put the negative electrode relay 13 of the first electricity storage device pack 10 in an open state. Thus, falling of the first electricity storage device pack 10 is completed. When falling of the first electricity storage device pack 10 and the second electricity storage device pack 20 are completed, the change processing S2 (see FIG. 2) is performed.

### <Change Processing S2>

The change processing S2 is processing of changing an electricity storage device pack that is to be a target of failure diagnosis at next startup. There is no particular limitation on a timing at which the change processing S2 is performed. The change processing S2 may be performed, for example, during startup of the electricity storage device system 1, may be performed after startup of the electricity storage device system 1, may be performed during falling of the electricity storage device system 1, and may be performed after falling of the electricity storage device system 1. In the controller 50 (in this embodiment, the storage 55a of the high-order controller 55), an order of failure diagnosis may be preset, and the electricity storage device pack that is to be a target of failure diagnosis may be read as appropriate at startup of the electricity storage device system 1.

In the controller 50 (in this embodiment, the storage 55a of the high-order controller 55), "the number of times of startup" of the electricity storage device system 1 is stored. After startup of the electricity storage device system 1 is completed, "1" is added to "the number of times of startup" that has been stored. Thus, the controller 50 recognizes at next startup that the startup is even-numbered startup. The second electricity storage device pack 20 is a target of failure diagnosis at the next startup. Note that failure diagnosis at even-numbered startup is executed by similar processing to that of failure diagnosis at odd-numbered startup. For the failure diagnosis at even-numbered startup, the processing of failure diagnosis at odd-numbered startup described above can be replaced as appropriate, and therefore, detailed description thereof will be omitted.

Incidentally, when an electricity storage device system including multiple electricity storage device packs is started up, a failure of a relay of an electricity storage device can be diagnosed. At failure diagnosis, before startup, it takes time to open and close a relay and to determine whether there is a failure at opening and closing of the relay. When a failure of a relay is diagnosed for all of the multiple electricity storage device packs, it can take a long time before startup of the electricity storage device system.

In the embodiment described above, the relay failure diagnosing method is a relay failure diagnosing method for the electricity storage device system 1 that includes the multiple electricity storage device packs 10 and 20. The relay failure diagnosing method is executed by the controller 50. The relay failure diagnosing method includes the diagnosis processing S1 and the change processing S2. In the diagnosis processing S1, a failure of a relay is diagnosed for one of the electricity storage device packs 10 and 20 at startup of the electricity storage device system 1. In the change processing S2, the electricity storage device pack that is to be a target of failure diagnosis is changed. In the diagnosis processing S1, failure diagnosis is performed on only one or some of the electricity storage devices included in the electricity storage device system 1, and therefore, time required for performing failure diagnosis is reduced. As a result, time required for starting up the electricity storage device system 1 is reduced. In the change processing S2, the electricity storage device pack on which failure diagnosis is performed at next startup is changed, and therefore, failure diagnosis is performed sequentially on the multiple electricity storage device packs 10 and 20 through multiple times of use. Thus, both of reduction of a startup time of the electricity storage device system 1 and inspection of the electricity storage device system 1 are can be easily achieved.

In the embodiment described above, the electricity storage device pack that is to be a target of failure diagnosis is changed in accordance with the number of times of startup. Thus, in the change processing S2, the electricity storage device that is to be a target of failure diagnosis is changed such that each of one or some of the electricity storage device packs on which failure diagnosis has been performed in the diagnosis processing S1 (in this embodiment, the first electricity storage device pack 10) is not a target of failure diagnosis at next startup. Therefore, at every startup, the same electricity storage device pack does not successively become a target of failure diagnosis, and the electricity storage device packs 10 and 20 included in the electricity storage device system 1 are likely to be evenly inspected.

In the embodiment described above, failure diagnosis is performed alternately on the electricity storage device pack 10 and the electricity storage device pack 20. In the change processing S2, the electricity storage device pack that is to be a target of failure diagnosis is changed in accordance with the preset order of failure diagnosis. Thus, at every startup, the same electricity storage device pack does not successively become a target of failure diagnosis. The electricity storage devices 11 and 21 included in the electricity storage device system 1 are more likely to be evenly inspected.

In the embodiment described above, in the controller 50, as the diagnosis processing S1, for the electricity storage device pack 10, processing of switching one (the negative electrode relay 13) of the positive electrode relay 12 and the negative electrode relay 13 that are set in an open state to a close state is executed (Step S14). In the controller 50, processing of, after switching one of (the negative electrode relay 13) of the positive electrode relay 12 and the negative electrode relay 13 to a close state, switching the other one (the positive electrode relay 12) of the positive electrode relay 12 and the negative electrode relay 13 to a close state is executed (Step S17). In the controller 50, processing of diagnosing failures of the positive electrode relay 12 and the negative electrode relay 13, based on the voltage of the electricity storage device 11 of the electricity storage device pack 10 that has been detected by the voltage sensor 15, is executed (Step S16 and Step S19). According to the diagnosis processing S1 described above, a failure of a relay can be diagnosed in accordance with startup of the electricity storage device pack 10. As a result, a time required for failure diagnosis for a relay is reduced. Note that relay opening and closing processing in the diagnosis processing S1 is not limited to a form described above. A timing of switching from an open state to a close state may be switched between the positive electrode relay 12 and the negative electrode relay 13.

In the embodiment described above, the controller 50 includes the high-order controller 55 and the low-order controllers 51 and 52. Tue high-order controller 55 transmits an inspection instruction to the low-order controllers 51 and 52 of the electricity storage device pack on which failure diagnosis is to be performed. The high-order controller 55 changes the electricity storage device pack that is to be a target of failure diagnosis as appropriate. Each of the low-order controllers 51 and 52 diagnoses a failure of a relay for a corresponding one of the electricity storage device packs 10 and 20. For each of the high-order controller 55 and the low-order controllers 51 and 52, separate processing is executed. Therefore, processing of synchronizing the low-order controllers 51 and 52 is not needed. A wiring or the like used for transmitting and receiving information between the low-order controllers 51 and 52 is not needed. As a result, processing executed in the entire controller 50 can be simplified. Moreover, failure diagnosis can be shortened.

Note that the change processing S2 in which the electricity storage device pack that is to be a target of failure diagnosis is changed is not limited to the embodiment described above. Although, in the embodiment described above, failure diagnosis is repeatedly performed at every startup alternately on the multiple electricity storage device packs 10 and 20 such that failure diagnosis is performed on the electricity storage device packs 10 and 20 at the same frequency, frequency of failure diagnosis may be different between the electricity storage device packs 10 and 20. When an electricity storage device system includes multiple electricity storage device packs degradation levels of which are different because the multiple electricity storage device packs were manufactured at different times or the like, an electricity storage device pack that is to be a target of failure diagnosis may be determined in accordance with the degradation level. In change processing, the electricity storage device pack that is to be a target of failure diagnosis at next startup may be determined such that the more an electricity storage device pack is degraded, the higher a frequency at which failure diagnosis is performed for the electricity storage device pack becomes. In the change processing S2, the electricity storage device pack that is to be a target of failure diagnosis at next startup may be determined at random.

In the change processing S2, the electricity storage device pack that is to be a target of failure diagnosis may be changed based on the voltage of the electricity storage device (or cell) included in the electricity storage device system. The electricity storage device pack that is to be a target of failure diagnosis may be changed based on a total voltage of each of the multiple electricity storage device packs connected in parallel. In this case, in the change processing S2, an electricity storage device pack the total voltage of which is high, among the multiple electricity storage device packs, is selected as a target of failure diagnosis. The electricity storage device pack that is to be a target of failure diagnosis may be changed based on a maximum value for voltages of cells included in the multiple electricity storage device packs. In this case, in the change processing S2, among the cells included in the multiple electricity storage device packs, an electricity storage device pack including a cell a voltage of which is maximum is selected as a target of failure diagnosis. The electricity storage device pack that is to be a target of failure diagnosis may be changed based on a minimum value for voltages of cells included in the multiple electricity storage device packs. In this case, in the change processing S2, among the cells included in the multiple electricity storage device packs, an electricity storage device pack including a cell having a minimum voltage can be selected as a target of failure diagnosis. The electricity storage device pack that is to be a target of failure diagnosis is changed based on a voltage of an electricity storage device included in the electricity storage device system, and thus, a failure of a relay of an electricity storage device pack is likely to be diagnosed at an early stage.

The diagnosis processing S1 is not necessarily executed at every startup. For example, when startup of the electricity storage device system 1 is performed after a preset interval has elapsed since the previous diagnosis processing S1, the diagnosis processing S1 may be executed. When startup of the electricity storage device system 1 is performed before the preset interval elapses since the previous diagnosis processing S1, the diagnosis processing S1 may not be executed. The interval that is a reference based on which whether the diagnosis processing S1 is executed is determined may be set in accordance with date and time of a startup interval. The interval that is the reference may be stored in, for example, the storage 55a of the high-order controller 55. Date and time of execution of the previous diagnosis processing S1 may be stored in the storage 55a. The instructor 55b of the high-order controller 55 may be configured to, when a difference between the date and time of execution of the previous diagnosis processing S1 and current date and time on which the electricity storage device system 1 is to be started up is equal to or more than the interval that is the reference, transmit an inspection instruction to the low-order controllers 51 and 52 such that the diagnosis processing S1 is executed.

In the embodiment described above, the electricity storage device system 1 includes the two electricity storage device packs 10 and 20. However, the electricity storage device system 1 is not limited thereto. The electricity storage device system may include three or more electricity storage device packs. In diagnosis processing, a failure of a relay may be diagnosed for at least two electricity storage device packs (and of a number less than the number of electricity storage device packs included in the electricity storage device system). Thus, many electricity storage device packs can be diagnosed by performing diagnosis a small number of times. As a result, a time that it takes to perform failure diagnosis for all of the electricity storage device packs included in the electricity storage device system can be reduced.

The relay failure diagnosing method exemplified herein may be realized by a program that a controller is caused to execute. The relay failure diagnosing method may be configured as a computer system that includes a memory (for example, the storage 55a of the high-order controller 55) that stores the program and one or more processors that can execute the program stored in the memory.

The technology disclosed herein has been described above in various forms. However, the embodiments described above or the like shall not limit the present invention, unless specifically stated otherwise. Various changes can be made to the technology disclosed herein, and each of components and processes described herein can be omitted as appropriate or can be combined with another one or other ones of the components and the processes as appropriate, unless a particular problem occurs. The present specification includes disclosure set forth in the following items.

First item: A relay failure diagnosing method for an electricity storage device system that includes multiple electricity storage device packs, the relay failure diagnosing method being executed by a controller, the relay failure diagnosing method comprising diagnosis processing of diagnosing a failure of a relay for one or some of the multiple electricity storage device packs at startup of the electricity storage device system, and change processing of changing an electricity storage device pack that is to be a target of failure diagnosis.

Second Item: The relay failure diagnosing method according to the first item, in which in the change processing, the electricity storage device pack that is to be a target of failure diagnosis is changed such that each of the one or some of the multiple electricity storage device packs on which failure diagnosis has been performed in the diagnosis processing is not a target of failure diagnosis at next startup of the electricity storage device system.

Third Item: The relay failure diagnosing method according to the first or second item, in which an order of failure diagnosis for the multiple electricity storage device packs is stored in the controller, and in the change processing, the electricity storage device pack that is to be a target of failure diagnosis is changed in accordance with the order.

Fourth Item: The relay failure diagnosing method according to any one of the first to third items, in which the electricity storage device system includes three or more electricity storage devices, and in the diagnosis processing, a failure of a relay is diagnosed for at least two electricity storage device packs.

Fifth Item: The relay failure diagnosing method according to any one of the first to fourth items, in which each of the multiple electricity storage device packs includes an electricity storage device that includes a positive electrode and a negative electrode, a positive electrode relay connected to a positive electrode side of the electricity storage device, and a negative electrode relay connected to a negative electrode side of the electricity storage device, and the controller controls opening and closing of the positive electrode relay and the negative electrode relay, the positive electrode relay and the negative electrode relay of each of the one or some of the multiple electricity storage device packs are set to an open state at startup of the electricity storage device system, the diagnosis processing includes, for the one or some of the multiple electricity storage device packs, processing of switching one or more relays having one of polarities among the positive and negative electrode relays that have been set in the open state to a close state, processing of switching, after switching the one or more relays having one of the polarities to the close state, switching one or more relays having the other one of the polarities to a close state, and processing of diagnosing a failure of each of the positive and negative electrode relays, based on a voltage of the electricity storage device of a corresponding one of the one or some of the multiple electricity storage device packs.

Sixth Item: A program for causing a controller to execute the relay failure diagnosing method according to any one of the first to fifth items.

Seventh Item: A computer system including a memory that stores the program according to the sixth item, and one or more processors that can execute the program stored in the memory.

Eighth Item: An electricity storage device system including multiple electricity storage device packs connected in parallel, and a controller, in which the controller is configured to execute processing of diagnosing a failure of a relay of one or some of the multiple electricity storage device packs at startup, and processing of changing an electricity storage device pack that is a target of failure diagnosis at every startup.

## Claims

1. A relay failure diagnosing method for an electricity storage device system (1) that includes multiple electricity storage device packs (10,20), the relay failure diagnosing method being executed by a controller (50), the relay failure diagnosing method comprising:
diagnosis processing (S1) of diagnosing a failure of a relay for one or some of the multiple electricity storage device packs (10,20) at startup of the electricity storage device system (1); and
change processing (S2) of changing an electricity storage device pack that is to be a target of failure diagnosis.

2. The relay failure diagnosing method according to claim 1, wherein
in the change processing (S2), the electricity storage device pack that is to be a target of failure diagnosis is changed such that each of the one or some of the multiple electricity storage device packs (10,20) on which failure diagnosis has been performed in the diagnosis processing (S1) is not a target of failure diagnosis at next startup of the electricity storage device system (1).

3. The relay failure diagnosing method according to claim 1, wherein
an order of failure diagnosis for the multiple electricity storage device packs (10,20) is stored in the controller (50), and
in the change processing (S2), the electricity storage device pack that is to be a target of failure diagnosis is changed in accordance with the order.

4. The relay failure diagnosing method according to claim 1, wherein
the electricity storage device system (1) includes three or more electricity storage devices, and
in the diagnosis processing (S1), a failure of a relay is diagnosed for at least two electricity storage device packs.

5. The relay failure diagnosing method according to any one of claims 1 to 4, wherein
each of the multiple electricity storage device packs (10,20) includes
an electricity storage device (11,21) that includes a positive electrode and a negative electrode,
a positive electrode relay (12,22) connected to a positive electrode side of the electricity storage device (11,21), and
a negative electrode relay (13,23) connected to a negative electrode side of the electricity storage device (11,21), and
the controller (50) controls opening and closing of the positive electrode relay (12,22) and the negative electrode relay (13,23),
the positive electrode relay (12,22) and the negative electrode relay (13,23) of each of the one or some of the multiple electricity storage device packs (10,20) are set to an open state at startup of the electricity storage device system (1),
the diagnosis processing (S1) includes, for the one or some of the multiple electricity storage device packs (10,20),
processing of switching one or more relays having one of polarities among the positive and negative electrode relays (12,13,22,23) that have been set in the open state to a close state,
processing of switching, after switching the one or more relays having one of the polarities to the close state, switching one or more relays having the other one of the polarities to a close state, and
processing of diagnosing a failure of each of the positive and negative electrode relays (12,13,22,23), based on a voltage of the electricity storage device (11,21) of a corresponding one of the one or some of the multiple electricity storage device packs (10,20).

6. A program for causing a controller (50) to execute the relay failure diagnosing method according to any one of claims 1 to 4.

7. A computer system comprising:
a memory that stores the program according to claim 6; and
one or more processors that can execute the program stored in the memory.

8. An electricity storage device system (1) comprising:
multiple electricity storage device packs (10,20) connected in parallel; and
a controller (50),
wherein
the controller (50) is configured to execute
processing of diagnosing a failure of a relay for one or some of the multiple electricity storage device packs (10,20) at startup, and
processing of changing an electricity storage device (10,20) pack that is a target of failure diagnosis at every startup.
